(19) Europäisches Patentamt
European Patent Office
Office européen des brevets

(11) **EP 3 583 622 B1**

(12) **EUROPEAN PATENT SPECIFICATION**

(45) Date of publication and mention
of the grant of the patent:
**14.04.2021 Bulletin 2021/15**

(51) Int Cl.:
***H01L 23/373*** *(2006.01)*  ***G06F 1/20*** *(2006.01)*
***H05K 7/20*** *(2006.01)*

(21) Application number: **17708996.8**

(22) Date of filing: **20.02.2017**

(86) International application number:
**PCT/EP2017/053804**

(87) International publication number:
**WO 2018/149512 (23.08.2018 Gazette 2018/34)**

(54) **THERMAL DISSIPATION AND ELECTRICAL ISOLATING DEVICE**

WÄRMEABLEITUNG UND ELEKTRISCHE ISOLATIONSVORRICHTUNG

DISPOSITIF D'ISOLATION ÉLECTRIQUE ET DE DISSIPATION THERMIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.12.2019 Bulletin 2019/52**

(73) Proprietor: **Lohmann GmbH & Co. KG
56567 Neuwied (DE)**

(72) Inventor: **APELGREN, Patrik
442 35 Kungälv (SE)**

(74) Representative: **Okoampah, Rene
df-mp Dörries Frank-Molnia & Pohlman
Patentanwälte Rechtsanwälte PartG mbB
Theatinerstraße 16
80333 München (DE)**

(56) References cited:
**WO-A1-2015/155940       JP-A- 2006 188 022
JP-A- 2009 117 594       JP-A- 2013 203 965
JP-A- 2016 219 527       US-A1- 2005 270 746
US-A1- 2006 098 413**

**Description**

Technical Field

The invention relates to a thermal dissipation and electrical isolating device for use in electronic devices, comprising a laminate of at least one graphite sheet and at least two adhesive layers.

Technological Background

Thermal or heat dissipation or spreading or thermal conductivity are expressions which are synonymously used in this application for processes in which heat is dissipated and spread from the spot where it is created, the so-called "hot spot", to a larger area, thus preventing overheating and defects of electronic devices.

Modern electronic devices like computers, cameras, mobile phones, sensor devices, LED lamps etc. constantly require higher CPU (central processing unit) or LED power. Typically, these devices consist of electronic circuits surrounded by plastic casings, for example, made from PC/ABS (polycarbonate/acrylonitrile butadiene styrene copolymer) or similar materials. These materials show only limited thermal conductivity. Traditionally thermal gap pads are used to spread heat from the hot spot to a heat sink part in the casing or to the casing itself which has a low heat conductivity. The heat dissipation takes place in a very limited and narrow space in the electronic device, the danger of over-heating this limited space and then malfunction of the device is high.

Heat-conductive or thermally conductive adhesive films exist in a great variety of products. Thermally conductive adhesives are especially used in high performance electronics. If heat sinks or radiators are bonded the thermally conductive adhesives used here are necessary in order to reduce the thermal load and thus to maintain the performance of the electronic parts. Heat-conductive adhesives are also employed as encapsulating mass for measuring sensors used in temperature measurement applications of reactors or electronic encasings.

In general, thermally conductive adhesives are two-component adhesives based on epoxides or silicones, often containing metallic or inorganic fillers which provide for heat conductivity.

In general, the heat conductivity of adhesives is lower than that of thermally conductive pastes and so a higher layer thickness is required to reach comparable results in terms of heat conductivity.

Therefore, several aspects have to be considered when choosing the appropriate adhesive for special applications: A higher amount of fillers improves the heat conductivity but at the same time diminishes the strength of the adhesive connection. If the amount of the adhesive is too high, considerable differences of expansion may be possible (CTE mismatch = Coefficient of Thermal Expansion mismatch) and then finally result in a debonding process since organic substances have a relatively high coefficient of expansion compared with inorganic materials. Heat-conductive adhesives based on epoxides have better conductivity values due to their tighter crosslinking compared to silicones. However, if the adhesive additionally has to make up for mechanical tensions silicones are preferred.

Recently, there have been a lot of general literature references and patent applications on the usage of graphene or graphite in heat-conducting processes. Graphene, an ultra-thin layer of carbon atoms which are connected in honeycomb pattern, offers many application possibilities due to its outstanding electrical and heat conductivity combined with its high chemical and mechanical stability.

Although the outstanding properties of graphene and graphite regarding their conductivity have been known for a long time already there still was the problem to precisely form graphene and graphite layers. However, due to enormous interest in the usage of graphene and graphite a couple of different production processes have been developed recently.

Heat spreaders made from natural graphite sheet materials have already been known for a couple of years. These spreaders take advantage of the anisotropic thermal properties of natural graphite. Natural graphite exhibits a high thermal conductivity in the plane (x and y axis) of the sheet combined with a lower thermal conductivity through the thickness (z axis) of the sheet. As a result, a natural graphite sheet can function both as a heat spreader and as a thermal insulator and so can be used to eliminate localized hot spots in electronic components. It is the aim of many developments in this direction to replace a conventional thermal management system consisting of a heat sink and a cooling fan.

Heat spreaders are commonly used with electronic enclosures to move heat from hot spots to the walls of the enclosures. Various methods of spreading heat are well known in today's electronics. Heat spreaders are, for example, used in die level packaging to spread heat from the microprocessor chip into the packaging. Copper heat spreaders can be found in many multi-chip modules, heat pipes are used to move heat from chip packages to heat sinks. Heat sinks themselves can incorporate spreaders based on copper or heat pipes embedded in an aluminum base. Passive heat spreaders are often part of plasma display panels.

As a consequence of the growing number and usage of electronic devices and the growing need of effectively spread away heat from the hot spots of the electronic devices and thus preserve their integrity and functionality a lot of patent applications and patents currently exist both on possible production processes of graphene or graphite in film form and, for example, on the use of graphene in the form of nanotubes as an electrically or a thermally conductive material.

WO 2008/149920 A1, for example, describes a graphite composite film having a graphite sheet and a pressure sensitive adhesive layer combined as a heat dissipation component in electronic devices..

CN 106061193 A claims a manufacturing process of a graphite sheet laminate stack.

CN 101712217 A concerns a thermally-conductive graphite interface material and production process thereof.

CN 103043301 A describes a graphite heat conducting film. The double-sided adhesive layer is larger than the edge positions of the edges of the graphite sheet.

However, using graphite sheets in a combination with electronic devices raises the risk of galvanic corrosions and circuit faults within the electronic device.

Accordingly, there is a need to provide a device that overcomes the drawbacks of the cited prior art. In particular, there is the need to prevent contamination of the electronic devices by graphite fibers.

US 2005/270746 A1 discloses an insulating structure having combined insulating and heat spreading capabilities.

US 2006/098413 A1 discloses a heat spreader for a display device.

JP 2006-188022 A discloses a carbon graphite sheet.

JP 2009-117594 A discloses a thin film thermal diffusion sheet.

WO 2015/155940 A1 and US 2017/110385 A1 disclose a heat-conductive sheet and a production method therefor.

JP 2013-203965 A discloses a colored adhesive tape and graphite composite sheet.

JP 2016-219527 A discloses a thermal conductive sheet.

Summary of the invention

It is an object of the present invention to provide an improved device for thermal dissipation and electrical isolation.

According to a first aspect, a thermal dissipation and electrical isolating device for use in electronic devices, is suggested, which comprises a laminate of at least one graphite sheet and at least a first adhesive layer having a horizontal thermal conductivity of more than 220 W/mK and being configured to prevent the graphite sheet from contacting the electronic device in order to prevent galvanic corrosions and circuit faults.

By adding the thermal dissipation and electrical isolating device to an electronic device the necessary heat dissipation over a larger area inside a casing of the electronic device is achieved. As a consequence the heat is less concentrated in a small area and the danger of overheating is considerably reduced.

For example, it is possible that heat created by a hot spot (e.g. by LEDs) on a front side of a printed circuit board (PCB) to be dissipated in the x-, y- and z-planes on the backside of the PCB and prevent overheating of the electronic device.

The natural property of graphite is its high thermal conductivity. On the other hand graphite is also a semi-conductor with a certain electrical conductivity. Since in many heat-sink applications this electrical conductivity is not desired, a carrierless transfer tape is added to one side or both sides of the graphite to provide an electrical isolation and thus prevent electrical conductivity.

In addition, in comparison to non-adhesive heat-conducting pastes thermally conductive adhesives have the advantage of not only conducting thermal energy but of also fixing and bonding electronic components at the same time.

The graphite sheet is sandwiched between two adhesive layers. Thereby, the risk of galvanic corrosions and circuit faults in terms of an electronic device may be reduced further.

In a further embodiment the thermal dissipation and electrical isolating device comprises at least one carrier and at least one second adhesive layer, wherein the first adhesive layer, the carrier, and the second adhesive layer form a carrier based adhesive tape, sheet, or die cut on at least one side of the graphite sheet. Since in many heat-sink applications electrical conductivity is not desired, hence, a double-sided adhesive tape with a film carrier or a single-sided adhesive tape with a film carrier is added to one side or both sides of the graphite sheet to provide an electrical isolation and thus prevent electrical conductivity.

According to a further aspect of the invention, the thickness of one adhesive layer is between 6 and 12 $\mu$m. Thus, the graphite sheet can be isolated appropriately so that galvanic corrosion and/or circuit faults can be prevented effectively.

In a further preferred embodiment the thickness of the graphite sheet is between 12 $\mu$m and 500 $\mu$m. The thickness of the graphite layer plays an important role in terms of surface contact: Due to tolerances and structures of back casings, for example, a thin hard material is less likely to contact the surface structures properly often resulting in micro bubbles or air pockets. In this regard, a thick graphite layer of 500 $\mu$m has a lower heat conductivity (available films of this thickness provide a heat conductivity of only 200 W/mK) but since it is softer than thinner layers its contact to surfaces is generally better.

The adhesive layers bleed out at their ends and thus completely enclose the graphite sheet.

According to a further embodiment, to be understood as modified to incorporate the adhesive layers on top and below the graphite layer bleeding out at their ends and thus completely enclosing the graphite layer, the thermal dissipation and electrical isolating device further comprises a gap pad disposed on the surface of the device in order to focus heat dissipation exactly to the area where the heat is created. Hence, the heat from a heat source can be restricted first of all to the limited area of the gap pad and from there it can be transferred to the larger area of the heat-dissipative graphite sheet. Thereby, the heat can be conducted away from the greatest part of heat-sensitive parts of the electronic device, which means a higher protection against possible damages by heat.

In yet another embodiment, to be understood as modified to incorporate the adhesive layers on top and below the graphite layer bleeding out at their ends and thus completely enclosing the graphite layer, the gap pad is in direct contact with the graphite sheet. Thereby heat conduction from the gap pad to the graphite sheet can be improved.

In a further embodiment, to be understood as modified to incorporate the adhesive layers on top and below the graphite layer bleeding out at their ends and thus completely enclosing the graphite layer, the thermal dissipation and electrical isolating device further comprises a foam core, wherein the foam core, is at least partially surrounded by the graphite sheet, and wherein the graphite sheet is fixed to the foam core by means of the first adhesive layer and/or the second adhesive layer.

This promotes heat absorption and provides isolation against the heat source. The soft foam core provides a certain elasticity to the system and since it contains air bubbles or air tunnels, it can already absorb to a certain extent part of the heat which needs to be dissipated and on the other hand provides some sort of isolation against the heat sources. This device is then fixed either to the hot spot or to the casing or to both with the help of another carrier-based or carrierless double-sided adhesive tape or with the help of two more carrier-based or carrierless double-sided adhesive tapes.

It is a further object of the present invention to provide a system comprising a thermal dissipation and electrical isolating device according to one of the aforementioned aspects, and an electronic device comprising a casing, wherein the adhesive layers on top and below the graphite layer bleed out at their ends and thus completely enclose the graphite layer, and wherein the ends of the graphite sheet are sealed in that the device completely fills the length and/or the width of the casing of the electronic device. Since both ends of the adhesive heat-dissipative construction are intended to contact the casing, the edges of the graphite sheet and the adhesive tape need not to be sealed in order to prevent graphite fibers from contaminating the device and so causing galvanic corrosions and circuit faults.

In a further embodiment of the system a gap pad is disposed between the thermal dissipation and electrical isolating device and at least one of a PCB and a CPU of the electronical device. Thereby, the heat is conducted away from the greatest part of the PCB, which means a higher protection of the PCB against possible damages by heat.

Brief description of the drawings

The present disclosure will be more readily appreciated by reference to the following detailed description when being considered in connection with the accompanying drawings in which:

Figure 1    is a schematic cross-sectional side view of a thermal dissipation and electrical isolating device comprising one double sided adhesive tape This embodiment does not form part of the invention.

Figure 2    is a schematic cross-sectional side view of a thermal dissipation and electrical isolating device comprising two double sided adhesive tapes.

Figure 3    is a schematic cross-sectional side view of the device of Fig. 2, having sealed ends This embodiment does not form part of the invention.

Figure 4    is a schematic cross-sectional side view of a thermal dissipation and electrical isolating device comprising foam core.

Figure 5    is a schematic cross-sectional side view showing the device of figure 3 integrated in an electronic device.

Figure 6    is a schematic cross-sectional side view showing the device of figure 2 integrated in an electronic device.

Figure 7    is a schematic cross-sectional view of a sample.

Figure 8    is a schematic cross-sectional view of the sample of Figure 6 showing the heat flow indicated by arrows.

Detailed description of preferred embodiments

In the following, the invention will be explained in more detail with reference to the accompanying figures. In the figures, like elements are denoted by identical reference numerals and repeated description thereof may be omitted in order to avoid redundancies.

In all cases described now one of the two carrier-based double-sided adhesive tapes can alternatively be a single-sided adhesive tape since the fixation inside a casing is provided by the double-sided adhesive tape and the opposite site of the construction need not be fixed to another surface.

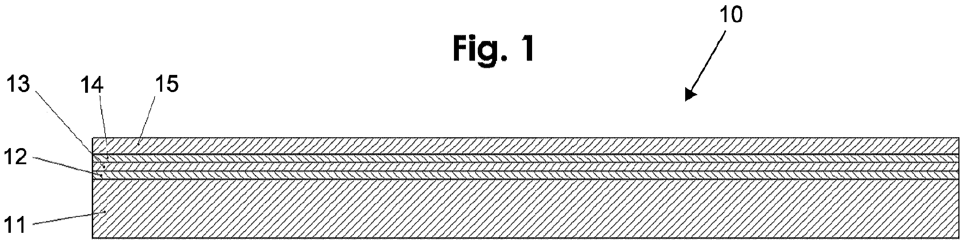

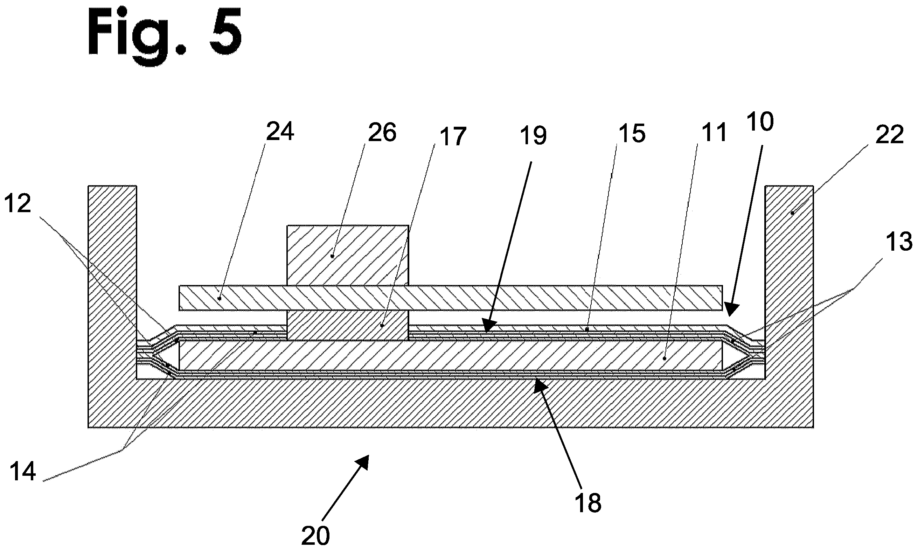

Fig. 1 shows: a graphite sheet 11 covered by a carrier-based double-sided adhesive tape 18, wherein the adhesive tape comprises an adhesive layer 12, a carrier 13, and an adhesive layer 14. In an electronic device 20, the graphite sheet 11 together with the adhesive tape 18 exactly fills the space between the hot spot and the casing 22 of the electronic device 20, the graphite sheet 11 being in contact with the hot spot. Since both ends of the thermal dissipation and electrical isolating device 10 are intended to contact the casing 22, the edges of the graphite sheet 11 and the adhesive tape 18 need not be sealed in order to prevent graphite fibers from contaminating the electronic device 20 and so causing galvanic corrosions and circuit faults (see Fig. 5).

Fig. 1 further shows a release liner 15 that is attached to the side of the adhesive layer 14 facing away from the carrier 13. The release liner 15 improves the storing capability of the device 10. It can be removed prior to use.

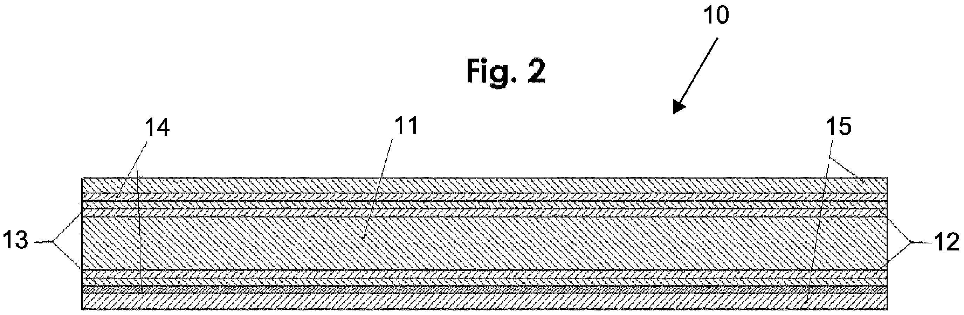

Fig. 2 shows in principle the same device as Fig. 1, the only difference being the usage of two carrier-based double-sided adhesive tapes 18 which are necessary to connect and fix the heat-conducting graphite sheet 11 both to the hot spot and to the casing. This device will provide a better electrical isolation compared to the usage of only one tape. Generally, carrierless adhesive transfer tapes (not shown in the figures) are also employable here but the electrical isolation will then probably not be as good as with carrier-based tapes.

Such a carrier-less lamination consists in its simplest form of three layers (adhesive layer - graphite layer - adhesive layer). This laminate is then exactly cut to size again at least according to the length of the special application site and placed inside the electrical appliance contacting the heat source, the bottom of the casing of the electrical device and both sides of the casing. Thus, the heat generated by the electrical appliance is again dissipated both in the x-y planes and in the z-plane. In order to improve electrical isolation and to prevent graphite fibers from contaminating the device and so causing galvanic corrosions and circuit faults this heat-dissipating construction at best either corresponds at least in length to the individual surface of the electronic device it is fixed to or has its edges sealed by adhesive so that in both cases the graphite sheet is completed enclosed. In a more sophisticated transfer tape-version according to the invention, the adhesive layers on top and below the graphite layer bleed out at their ends and thus completely enclose the graphite layer.

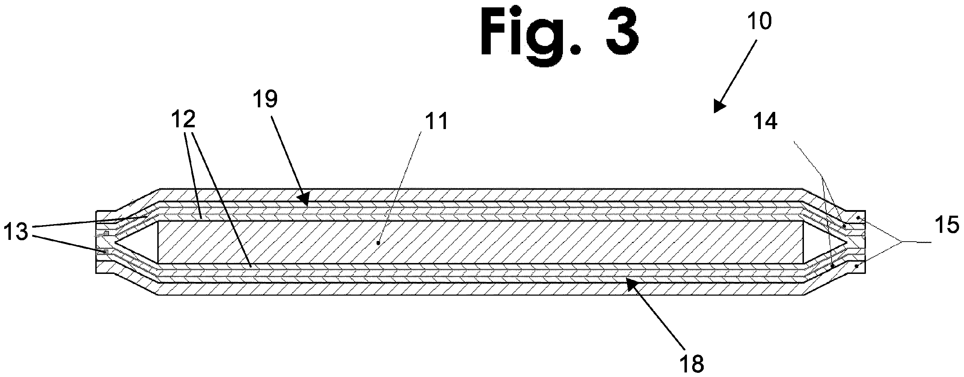

Another possibility which does not form part of the invention, to prevent graphite fibers from contaminating the electronic device and so causing galvanic corrosions and circuit faults is shown in Fig. 3: two carrier-based adhesive tapes 18 not only provide reliable fixation inside the electronic device but also seal both ends of the graphite sheet 11 by sticking the two tapes 18 together, thus completely enclosing the graphite sheet 11 and preventing both contamination of the graphite sheet 11 and of the other parts contained inside the casing of the electronic device. Alternatively, depending on the geometry of the casing it may be sufficient to seal only one end of graphite sheet 11.

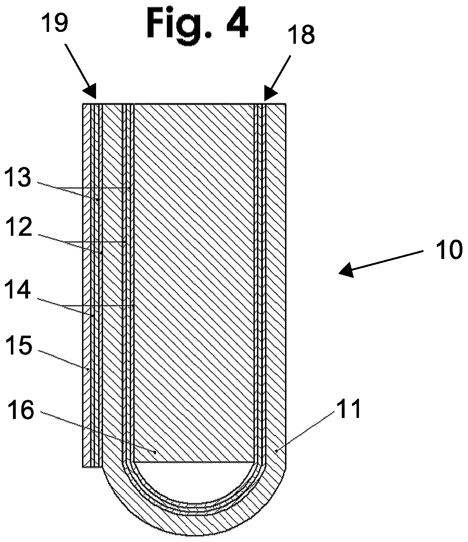

Another possible embodiment, to be understood as modified to incorporate the adhesive layers on top and below the graphite layer bleeding out at their ends and thus completely enclosing the graphite layer, of the thermal dissipation and electrical isolating device is shown in Fig. 4. A soft pad consisting of a polymer foam core 16, for example, from polyurethane or polyethylene is surrounded at least at one of its ends by a carrier-based or carrierless double-sided adhesive tape 18, the adhesive side away from the foam core 16 connects the foam core 16 with a graphite sheet 11 surrounding the foam core 16. The soft foam core 16 provides a certain elasticity to the device 10 and since it contains air bubbles or air tunnels, it can already absorb to a certain extent part of the heat which needs to be dissipated and on the other hand provides some sort of isolation against the heat sources. This device 10 is then fixed either to a hot spot or to a casing or to both with the help of another carrier-based or carrierless double-sided adhesive tape 19 or with the help of two carrier-based or carrierless double-sided adhesive tapes.

Depending on the electronic device and the requirements on heat dissipation stacks of constructions as they have been described herein can be manufactured and used, wherein stacks means that more than two adhesive layers and more than one graphite sheet alternately can be laminated together.

According to another embodiment, to be understood as modified to incorporate the adhesive layers on top and below the graphite layer bleeding out at their ends and thus completely enclosing the graphite layer, of the thermal dissipation and electrical isolating device 10 a small gap pad 17 is provided, for example, on a PCB 24. In Fig. 5 the graphite sheet 11 is laminated with two adhesive tapes 18, 19 with a film carrier 13, the thermal dissipation and electrical isolating device 10 is then placed onto the inner back casing 22 of the electronic device 20 completely covering this area. The length of the adhesive tapes 18, 19, and the release liner 15 matches the space inside the casing 22. Thereby it can be ensured that the graphite sheet 11 is isolated from the PCB 24, a CPU 26, and the casing 22.

A small gap pad 17, for example, made of silicone is then placed on the back side of the PCB 24 exactly opposite to where the CPU 26 is situated. Alternatively, other heat-conductive materials may be used.

Hence, the heat from the CPU 26 is restricted first of all to the limited area of the gap pad 17 and from there it is transferred to the larger area of the heat-dissipative graphite sheet 11. Thereby, the heat is conducted away from the greatest part of the PCB 24, which means a higher protection of the PCB 24 against possible damages by heat. The gap pad 17 is in direct contact with the graphite sheet 11. Alternatively, an adhesive layer or a carrier based adhesive tape is disposed between the gap pad and the graphite sheet.

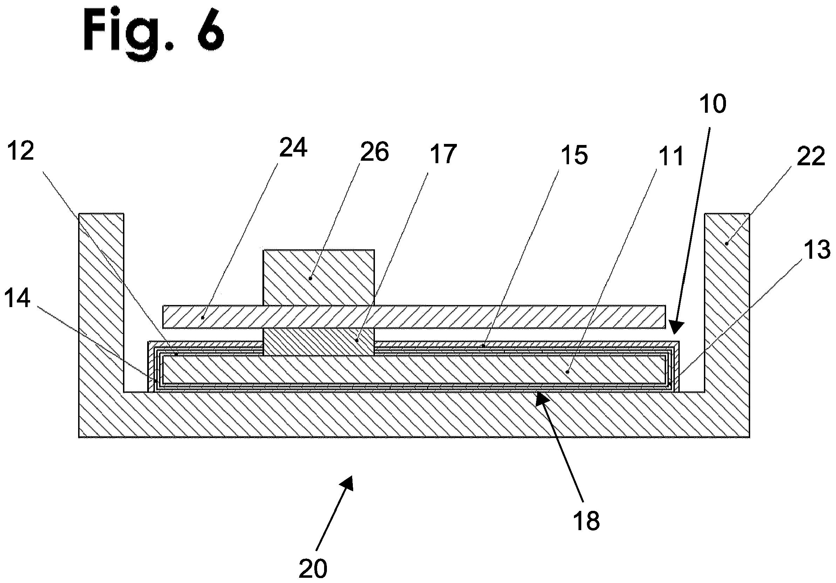

Fig. 6 shows an embodiment, to be understood as modified to incorporate the adhesive layers on top and below the graphite layer bleeding out at their ends and thus completely enclosing the graphite layer, of the thermal dissipation and electrical isolating device 10 similar to the one shown in Fig. 5. The device 10 of Fig. 6 differs from the device 10 shown in Fig. 5 in that also the lateral faces of the graphite sheet 11 are in contact with the adhesive layer 12. Thus, it is not necessary that the length of the device matches with the casing 22.

The thermal performance of the graphite sheets used in the device as described mainly depends on their density and purity. Graphite sheets from, for example, may indicate a thermal performance of 1,800 W/mK and a density of 2.13 g/cm$^3$ for a sheet with a thickness of 25 μm, a sheet with a thickness of 100 μm provides a heat conductivity of 700 W/mK and has a density of 0.85 g/m$^3$. The thickness of the graphite layer plays an important role in terms of surface contact: Due to tolerances and structures of back casings, for example, a thin hard material is less likely to contact the surface structures properly often resulting in micro bubbles or air pockets. In this regard, a thick graphite layer of 500 μm has a lower heat conductivity (available films of this thickness provide a heat conductivity of only 200 W/mK) but since it is softer than thinner layers its contact to surfaces is generally better.

As carrier materials of the adhesive tapes all sorts of plastics with dielectric properties can be used, for example, polyester or polypropylene.

Due to the normally small space available in electronic devices for the application of heat dissipative constructions these constructions are often subject to a certain compression within the devices. In view of that, adhesive shear strength or peel strength in general and especially at higher temperatures do not play a critical role here. So, in principle all sorts of adhesives like pressure sensitive adhesives or structural adhesives or combinations of them in the form of tapes, strips, rolls or even as liquids can be used here.

The heat-dissipative effect of the inventive laminations containing a graphite sheet can be improved by including thermally conductive fillers like, for example, carbon black, silica, alumina and the like in the carrier materials and/or the adhesives of the tapes.

The graphite sheets used in the inventive constructions can be any commercially available graphite sheets, the thicknesses ranging from 12 μm to 500 μm and thermal conductivity values in horizontal and vertical directions between 1,900/15 W/mK and 500/15 W/mK.

**Examples:**

**Materials used in sample 1:**

Graphite sheet of sample 1, covered on both sides by "DuploCOLL 97001", a double-sided acrylic adhesive tape with a carrier (thickness of the carrier: 4.5 μm and thickness of each adhesive layer: about 11 μm).

**Materials used in sample 2:**

Graphite sheet of sample 2, covered on both sides by "VT1038C", a single-sided acrylic adhesive tape with a carrier (thickness of the carrier: 4.5 μm and thickness of each adhesive layer: about 6 μm)

**Materials used in sample 3:**

Graphite sheet of sample 3, covered on one side by "DuploCOLL 97001" and on the other side by "VT1038C".
Typical properties of a graphite sheet used in these samples:

| Properties | Unit | |
|---|---|---|
| Thickness | Mm | 0.1 |
| Density | g/cm$^3$ | 0.85 |
| Thermal Conductivity (Horizontal/Vertical) | W/mK | 700/15 |
| Thermal Deflection | cm$^2$/s | 9-10 |
| Specific Heat | (50° C.)J/gk | 0.85 |
| Max. Temperature | °C. | 400 |
| Tensile Strength Horizontal/Vertical | MPA | 19.2/0.65 |
| Bending Strength (Bending Times R5/180°C.) | | 10,000 |

EP 3 583 622 B1

(continued)

| Properties | Unit | |
|---|---|---|
| Electrical Conductivity | s/cm | 20,000 |

**Measuring principles:**

Circular samples with a sample diameter of 170 mm, temperature measurement (dT) via infrared camera. Calculations have been carried out according to equation 1:

$$\lambda = \frac{\dot{Q} \cdot \ln\left(\frac{r_a}{r_i}\right)}{2 \cdot \pi \cdot D \cdot dT} \quad \left[\frac{W}{m\,K}\right]$$

$$(1)$$

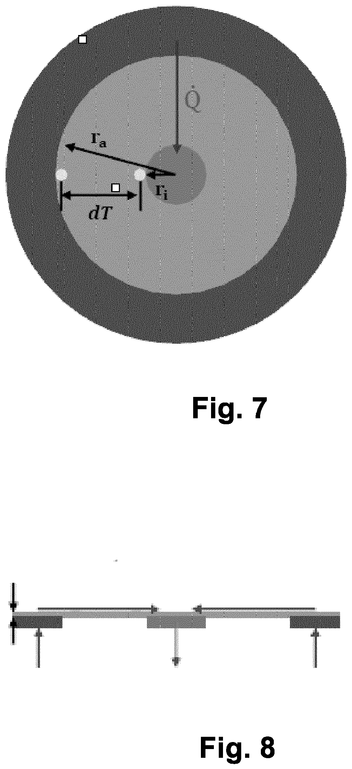

In Fig. 7 some of the terms of equation 1 are visually explained, wherein $\lambda$ represents the thermal conductivity, Q represents the heat flow, D represents the sample thickness, $r_a$ represents the inner radius of the sample, and $r_i$ represents the outer radius of the sample. Moreover, Fig. 8 shows a sectional side view of Fig. 7, wherein the arrows represent the heat flow Q.

**Test Results:**

| Sample | Thickness | Thermal Conductivity | Measurement uncertainty |
|---|---|---|---|
| | [mm] | W/mK | [%] |
| 1 | 0.154 | 222 | $\pm$ 7.8 |
| 2 | 0.134 | 258 | $\pm$ 7.5 |
| 3 | 0.130 | 248 | $\pm$ 8.0 |

List of reference numerals

10    Thermal dissipation and electrical isolating device
11    Graphite sheet
12    Adhesive layer
13    Carrier
14    Adhesive layer
15    Release liner
16    Foam core
17    Gap pad
18    Adhesive tape
19    Adhesive tape

20    Electronic device
22    Casing
24    PCB (printed circuit board)
26    CPU (central processing unit)

### Claims

1. A thermal dissipation and electrical isolating device (10) for use in an electronic device (20), comprising a laminate of at least one graphite sheet (11) and at least a first adhesive layer (12) being configured to prevent the graphite sheet (11) from contacting the electronic device (20) in order to prevent galvanic corrosions and circuit faults, wherein the laminate has a horizontal thermal conductivity of more than 220 W/mK, and wherein the graphite sheet (11) is sandwiched between two adhesive layers (12), **characterized in that**
the adhesive layers (12) bleed out at their ends and thus completely enclose the graphite sheet (11).

2. The thermal dissipation and electrical isolating device (10) according to claim 1 , wherein the device further comprises at least one carrier (13) and at least one second adhesive layer (14), wherein the first adhesive layer (12), the carrier (13), and the second adhesive layer (14) form a carrier based adhesive tape (18, 19), sheet, or die cut on at least one side of the graphite sheet (11).

3. The thermal dissipation and electrical isolating device (10) according to claim 1 or 2, wherein the thickness of one adhesive layer (12, 14) is between 6 and 12 $\mu$m.

4. The thermal dissipation and electrical isolating device (10) according to one of the preceding claims, wherein the thickness of the graphite sheet (11) is between 12 $\mu$m and 500 $\mu$m.

5. The thermal dissipation and electrical isolating device (10) according to one of the preceding claims, wherein the device comprises a gap pad (17) disposed on the surface of the device (10) in order to focus heat dissipation exactly to the area where the heat is created.

6. The thermal dissipation and electrical isolating device (10) according claim 5, wherein the gap pad (17) is in direct contact with the graphite sheet (11).

7. The thermal dissipation and electrical isolating device (10) according to one of the preceding claims, wherein the device comprises a foam core (16), wherein the foam core (16) is at least partially surrounded by the graphite sheet (11), and wherein the graphite sheet (11) is fixed to the foam core (16) by means of adhesive layer (12) and/or adhesive layer (14).

8. A system comprising a thermal dissipation and electrical isolating device (10) according to one of the preceding claims, and an electronic device (20) comprising a casing (22), wherein the ends of the graphite sheet (11) are sealed in that the device (10) completely fills the length and/or the width of the casing (22) of the electronic device (20).

9. The system according to claim 8, wherein a gap pad (17) is disposed between the thermal dissipation and electrical isolating device (10) and at least one of a PCB (24) and a CPU (26) of the electronic device (20).

### Patentansprüche

1. Vorrichtung (10) zur Wärmeableitung und elektrischen Isolierung zur Verwendung in einer elektronischen Vorrichtung (20), die ein Laminat aus mindestens einer Graphitfolie (11) und mindestens einer ersten Klebstoffschicht (12) umfasst, welche dazu eingerichtet ist, die Graphitfolie (11) daran zu hindern, die elektronische Vorrichtung (20) zu kontaktieren, um galvanische Korrosionen und Schaltungsstörungen zu verhindern,
wobei das Laminat eine horizontale Wärmeleitfähigkeit von mehr als 220 W/mK aufweist, und wobei die Graphitfolie (11) sandwichartig zwischen zwei Klebstoffschichten (12) angeordnet ist,
**dadurch gekennzeichnet, dass**
die Klebstoffschichten (12) an ihren Enden ausbluten und damit die Graphitfolie (11) vollständig umschließen.

2. Vorrichtung (10) zur Wärmeableitung und elektrischen Isolierung nach Anspruch 1, wobei die Vorrichtung weiter mindestens einen Träger (13) und mindestens eine zweite Klebstoffschicht (14) umfasst, wobei die erste Klebstoffschicht (12), der Träger (13) und die zweite Klebstoffschicht (14) auf mindestens einer Seite der Graphitfolie (11) ein Klebeband (18, 19), eine Folie oder ein Stanzerzeugnis auf Trägerbasis bilden.

3. Vorrichtung (10) zur Wärmeableitung und elektrischen Isolierung nach Anspruch 1 oder 2, wobei die Dicke der Klebstoffschicht (12, 14) zwischen 6 und 12 $\mu$m beträgt.

**4.** Vorrichtung (10) zur Wärmeableitung und elektrischen Isolierung nach einem der vorstehenden Ansprüche, wobei die Dicke der Graphitfolie (11) zwischen 12 $\mu$m und 500 $\mu$m beträgt.

**5.** Vorrichtung (10) zur Wärmeableitung und elektrischen Isolierung nach einem der vorstehenden Ansprüche, wobei die Vorrichtung ein Spalt-Pad (17) umfasst, das auf der Oberfläche der Vorrichtung (10) angeordnet ist, um Wärmeableitung exakt auf den Bereich zu konzentrieren, in dem die Wärme erzeugt wird.

**6.** Vorrichtung (10) zur Wärmeableitung und elektrischen Isolierung nach Anspruch 5, wobei sich das Spalt-Pad (17) in direktem Kontakt mit der Graphitfolie (11) befindet.

**7.** Vorrichtung (10) zur Wärmeableitung und elektrischen Isolierung nach einem der vorstehenden Ansprüche, wobei die Vorrichtung einen Schaumkern (16) umfasst, wobei der Schaumkern (16) mindestens teilweise von der Graphitfolie (11) umgeben ist, und wobei die Graphitfolie (11) mittels Klebstoffschicht (12) und/oder Klebstoffschicht (14) am Schaumkern (16) befestigt ist.

**8.** System, das eine Vorrichtung (10) zur Wärmeableitung und elektrischen Isolierung nach einem der vorstehenden Ansprüche, und eine elektronische Vorrichtung (20) umfasst, die ein Gehäuse (22) umfasst, wobei die Enden der Graphitfolie (11) dadurch versiegelt sind, dass die Vorrichtung (10) die Länge und/oder die Breite des Gehäuses (22) der elektronischen Vorrichtung (20) vollständig ausfüllt.

**9.** System nach Anspruch 8, wobei zwischen der Vorrichtung (10) zur Wärmeableitung und elektrischen Isolierung und zumindest einer Leiterplatte (24) oder einer CPU (26) der elektronischen Vorrichtung (20) ein Spalt-Pad (17) angeordnet ist.

## Revendications

**1.** Dispositif (10) d'isolation électrique et de dissipation thermique pour utilisation dans un dispositif électronique (20), comprenant un stratifié d'au moins une feuille de graphite (11) et d'au moins une première couche adhésive (12) étant configurée pour empêcher la feuille de graphite (11) d'entrer en contact avec le dispositif électronique (20) afin d'empêcher des corrosions galvaniques et des défauts de circuit,
dans lequel le stratifié présente une conductivité thermique de plus de 220 W/mK, et
dans lequel la feuille de graphite(11) est prise en sandwich entre les deux couches adhésives (12),
**caractérisé en ce que**
les couches adhésives (12) s'étalent à leurs extrémités et enferment donc complètement la feuille de graphite (11).

**2.** Dispositif (10) d'isolation électrique et de dissipation thermique selon la revendication 1, dans lequel le dispositif comprend en outre au moins un support (13) et au moins une seconde couche adhésive (14), dans lequel la première couche adhésive (12), le support (13), et la seconde couche adhésive (14) forment un ruban adhésif (18,19), une feuille ou une découpe à base d'un support sur au moins un côté de la feuille de graphite (11).

**3.** Dispositif (10) d'isolation électrique et de dissipation thermique selon la revendication 1 ou 2, dans lequel l'épaisseur de la couche adhésive (12, 14) se situe entre 6 et 12 $\mu$m.

**4.** Dispositif (10) d'isolation électrique et de dissipation thermique selon l'une quelconque des revendications précédentes, dans lequel l'épaisseur de la feuille de graphite (11) se situe entre 12 $\mu$m et 500 $\mu$m.

**5.** Dispositif (10) d'isolation électrique et de dissipation thermique selon l'une quelconque des revendications précédentes, dans lequel le dispositif comprend un

**6.** Dispositif (10) d'isolation électrique et de dissipation thermique selon la revendication 5, dans lequel le tampon d'espace (17) est en contact direct avec la feuille de graphite (11).

**7.** Dispositif (10) d'isolation électrique et de dissipation thermique selon l'une quelconque des revendications précédentes, dans lequel le dispositif comprend un noyau en mousse (16), dans lequel le noyau en mousse (16) est au moins partiellement entouré par la feuille de graphite (11), et dans lequel la feuille de graphite (11) est fixée au noyau en mousse (16) au moyen de couche adhésive (12) et/ou de couche adhésive (14).

**8.** Système comprenant un dispositif (10) d'isolation électrique et de dissipation thermique selon l'une quelconque des revendications précédentes, et un dispositif électronique (20) comprenant un boîtier (22), dans lequel les extrémités de la feuille de graphite (11) sont scellées en ce que le dispositif (10) remplit complètement la longueur et/ou la largeur du boîtier (22) du dispositif électronique (20).

**9.** Système selon la revendication 8, dans lequel un tampon d'espace (17) est disposé entre le dispositif (10) d'isolation électrique et de dissipation thermique et au moins une carte de circuit imprimé (24) ou une CPU (26) du dispositif électronique (20).

# Fig. 1

EP 3 583 622 B1

**Fig. 2**

Fig. 3

# Fig. 4

19    18

13

12

14

15

16    11

10

EP 3 583 622 B1

# Fig. 5

EP 3 583 622 B1

Fig. 6

**Fig. 7**

**Fig. 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008149920 A1
- CN 106061193 A
- CN 103043301 A
- US 2005270746 A1
- US 2006098413 A1
- JP 2006188022 A

- JP 2009117594 A
- WO 2015155940 A1
- US 2017110385 A1
- JP 2013203965 A
- JP 2016219527 A